(19) Europäisches Patentamt
European Patent Office
Office européen des brevets

(11) **EP 2 834 653 B1**

(12) **FASCICULE DE BREVET EUROPEEN**

(45) Date de publication et mention de la délivrance du brevet:
**25.09.2019 Bulletin 2019/39**

(51) Int Cl.:
***G01R 31/11*** *(2006.01)*

(21) Numéro de dépôt: **13711045.8**

(22) Date de dépôt: **21.03.2013**

(86) Numéro de dépôt international:
**PCT/EP2013/055884**

(87) Numéro de publication internationale:
**WO 2013/149839 (10.10.2013 Gazette 2013/41)**

(54) **PROCEDE ET SYSTEME DE DIAGNOSTIC D'UN CABLE PAR REFLECTOMETRIE DISTRIBUEE A MOYENNE AUTOSELECTIVE**

VERFAHREN UND SYSTEM ZUR DIAGNOSE EINES KABELS MITTELS VERTEILTER REFLEKTOMETRIE MIT SELEKTIVER DURCHSCHNITTBILDUNG

METHOD AND SYSTEM FOR DIAGNOSING A CABLE BY DISTRIBUTED REFLECTOMETRY WITH SELECTIVE AVERAGING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.04.2012 FR 1253054**

(43) Date de publication de la demande:
**11.02.2015 Bulletin 2015/07**

(73) Titulaire: **Commissariat à l'Énergie Atomique et aux Énergies Alternatives 75015 Paris (FR)**

(72) Inventeurs:
• **INCARBONE, Luca F-75015 Paris (FR)**
• **SOMMERVOGEL, Laurent F-78350 Jouy-en-Josas (FR)**

(74) Mandataire: **Hammes, Pierre Marks & Clerk France Immeuble Visium 22, avenue Aristide Briand 94117 Arcueil Cedex (FR)**

(56) Documents cités:
**FR-A1- 2 907 910   FR-A1- 2 937 146**

• **Adrien Lelong: "Méthodes de diagnostic filaire embarqué pour des réseaux complexes", , 9 décembre 2010 (2010-12-09), pages 1-167, XP055047458, agence bibliographique de l'enseignement supérieur Extrait de l'Internet: URL:http://www.theses.fr/2010LIL10121 [extrait le 2012-12-11]**

**EP 2 834 653 B1**

**Description**

La présente invention a pour objet un procédé et un système de diagnostic d'un câble ou d'un réseau de câbles par réflectométrie distribuée.

L'invention concerne le domaine de la réflectométrie qui permet la localisation d'un défaut dans un câble électrique.

La réflectométrie consiste à émettre un signal sur un câble ou un réseau de câbles puis à mesurer les échos renvoyés dus aux réflexions du signal injecté sur les singularités, ou discontinuités d'impédance, du câble. Le retard et l'amplitude de ces échos permettent d'obtenir des informations sur la structure ou sur les défauts électriques présents dans ce réseau. Plus généralement, chaque écho correspond à une singularité. On peut ainsi localiser, caractériser et éventuellement prédire une panne. Les méthodes classiques bien connues de réflectométrie sont la réflectométrie temporelle TDR (Time Domain Reflectometry) et la réflectométrie fréquentielle FDR (Frequency Domain Reflectometry).

L'invention concerne plus précisément la réflectométrie distribuée qui permet de réaliser simultanément des mesures de diagnostic en plusieurs points du câble à tester par le biais de plusieurs dispositifs de réflectométrie injectant un signal de test dans le câble en même temps.

La réflectométrie distribuée est particulièrement adaptée pour localiser des défauts ou des pannes impactant des câbles de longueur très importante, tels que des câbles de signalisation d'un réseau ferroviaire. Elle permet en outre, en cas d'apparition de deux défauts francs, de localiser la position des deux défauts et de déterminer la distance entre eux. Ce type de problème peut survenir si le câble est, par exemple, sectionné en deux points distincts dans le but d'enlever un segment entier du câble. Avec un seul réflectomètre, il n'est possible de détecter qu'un défaut ponctuel et l'on peut obtenir la distance qui le sépare du point d'injection du signal mais on ne peut pas déterminer la position d'un deuxième défaut, donc on ne peut pas déterminer la longueur d'un segment de câble prélevé. La réflectométrie distribuée permet notamment d'obtenir ce type d'information. Dans l'exemple mentionné, un deuxième réflectomètre est positionné en un second point du câble par exemple à une extrémité opposée au premier point d'injection. Si une portion du câble est coupée et enlevée, les informations produites par les deux dispositifs de réflectométrie permettent d'en déduire la position des deux défauts ainsi que la longueur de la portion de câble enlevée.

La réflectométrie distribuée permet de plus d'acquérir des mesures sur des distances plus importantes. En effet, si chaque réflectomètre peut surveiller une certaine longueur de câble, deux réflectomètres positionnés en deux points éloignés pourront surveiller une longueur double.

Le problème des méthodes de réflectométrie distribuée est que la mesure réalisée par un réflectomètre est parasitée par le ou les signaux de test du ou des autres réflectomètres. Ces perturbations sont d'autant plus contraignantes lorsque les différents réflectomètres qui composent le système distribué ne sont pas synchronisés temporellement entre eux.

Il est donc nécessaire d'appliquer un traitement spécifique sur le signal reçu afin d'éliminer cette perturbation sans quoi l'exploitation de la mesure est impossible. Ce traitement consiste à discriminer les signaux issus des différents réflectomètres afin de ne conserver que celui qui a été émis par le réflectomètre de référence.

On connait une première méthode de réflectométrie distribuée décrite dans la demande de brevet française FR2907910 du demandeur. Cette méthode consiste à utiliser des séquences pseudo aléatoires de type séquence M comme signal de test. L'objectif de la méthode est de minimiser l'intercorrélation, c'est-à-dire la ressemblance statistique de signaux, entre les séquences générées par les différents réflectomètres. Le post-traitement réalisé sur les mesures des signaux réfléchis consiste à appliquer un filtrage adapté comme cela se fait dans la méthode de réflectométrie connue STDR (Sequence Time Domain Reflectometry). Un inconvénient de cette méthode est qu'elle nécessite un post-traitement pour discriminer les mesures correspondant aux signaux injectés par les différents réflectomètres. En outre le profil du signal de test considéré n'est pas particulièrement adapté au diagnostic de câbles de longueur importante (plusieurs kilomètres) car l'atténuation du signal injecté influe sur les performances de l'algorithme de discrimination.

Une deuxième méthode de réflectométrie distribuée a fait l'objet de la demande de brevet internationale WO2010/043602 du demandeur. Cette méthode utilise un ensemble de coefficients de pondération pour moduler le signal de test et une moyenne pondérée des mesures du signal réfléchi. Les coefficients de pondération sont choisis orthogonaux les uns aux autres, de sorte que seul le signal provenant de la source voulue soit récupéré, le bruit d'interférence issu des autres sources étant annulé par le calcul de moyenne.

Cette méthode n'est cependant valable que lorsque le signal de test injecté est à moyenne nulle, ce qui ne peut pas être le cas par exemple d'une impulsion temporelle.

En effet, si une impulsion pleine échelle est injectée sur une ligne de longueur très importante, c'est-à-dire si l'on utilise toute la dynamique des convertisseurs, y compris du côté des tensions négatives, au moment du changement de coefficient de pondération, on observe une transition gênante qui résulte de l'effet d'un déchargement capacitif. Cette transition vient perturber la moyenne calculée ultérieurement et donc la mesure finale du réflectomètre.

On connait également la publication « Méthodes de diagnostic filaire embarqué pour des réseaux complexes », Adrien Lelong, 9 décembre 2010 qui décrit d'autres méthodes de réflectométrie distribuées.

L'invention permet de résoudre les limitations des méthodes de réflectométrie distribuée selon l'art antérieur précitées en introduisant un retard maitrisé entre les signaux injectés par les différents réflectomètres du système distribué.

L'invention a pour avantage de ne pas nécessiter de post-traitement de discrimination sur les mesures des signaux réfléchis. En outre l'invention est compatible de tout type de signal de test, y compris les signaux à moyenne nulle. Le signal de test peut utiliser toute la dynamique des convertisseurs. Cette caractéristique est particulièrement intéressante dans le cas du diagnostic de câbles très longs ou pour surveiller des distances importantes, de l'ordre de plusieurs kilomètres. En effet, pour de telles applications le signal de test injecté doit présenter un maximum d'énergie à l'injection pour limiter l'influence de l'atténuation du signal lors de sa propagation dans le câble.

L'invention s'applique au diagnostic de tout type de câbles électriques, d'énergie ou de communication et plus particulièrement à la détection de défauts électriques ou de coupures sur les câbles de signalisation d'un réseau ferroviaire.

L'invention a ainsi pour objet un procédé de test d'un câble par réflectométrie distribuée selon la revendication 1.

Dans une variante de réalisation, le procédé selon l'invention comporte en outre les étapes suivantes :

- injecter dans le câble, en un troisième point d'injection, un troisième signal périodique comportant le même nombre N de périodes et le même nombre M d'échantillons par période que ledit premier signal,
- si les périodes du deuxième signal sont injectées dans le câble avec un retard, injecter chaque période dudit troisième signal avec une avance,
- si les périodes du deuxième signal sont injectées dans le câble avec une avance, injecter chaque période dudit troisième signal avec un retard,
- la valeur absolue de l'avance ou du retard à l'injection d'une période du troisième signal étant prise égale à la valeur absolue du retard ou de l'avance à l'injection d'une période du deuxième signal.

Selon un aspect particulier de l'invention, la valeur absolue du retard ou de l'avance est nulle pour la première période et est égale à un écart temporel équivalent à un nombre K d'échantillons de signal pour chaque période successive.

Selon un autre aspect particulier de l'invention pour obtenir le retard ou l'avance, chaque période est augmentée ou diminuée d'un nombre K d'échantillons.

Selon un autre aspect particulier de l'invention le nombre d'échantillons M d'une période est égal à K fois le nombre N de périodes sur lequel est réalisée la moyenne.

Dans une variante de réalisation de l'invention, lesdits signaux périodiques sont sélectionnés parmi les signaux suivants : une impulsion temporelle, un créneau temporel, un signal triangulaire, un signal à moyenne nulle.

L'invention a aussi pour objet un système de réflectométrie distribuée comprenant au moins un premier et un second dispositifs de test par réflectométrie disposés en au moins deux points distincts d'un même câble à tester caractérisé en ce que chaque dispositif comprend des moyens adaptés à mettre en oeuvre le procédé de test selon l'invention.

D'autres caractéristiques et avantages de la présente invention apparaîtront mieux à la lecture de la description qui suit en relation aux dessins annexés qui représentent:

- la figure 1, un schéma d'un système de réflectométrie distribué selon l'invention,
- les figures 2a et 2b, un exemple de signal de test généré par un réflectomètre,
- la figure 3, une illustration, sur plusieurs chronogrammes, du problème de désynchronisation entre deux réflectomètres d'un système distribué,
- la figure 4, une représentation, sur deux chronogrammes, des signaux de test injectés par deux réflectomètres d'un système distribué selon l'invention,
- la figure 5, une représentation, sur trois chronogrammes, des signaux de test injectés par trois réflectomètres d'un système distribué selon une variante de réalisation de l'invention,
- la figure 6, une représentation d'un signal de test triangulaire pour le diagnostic de câbles de longueur importante.

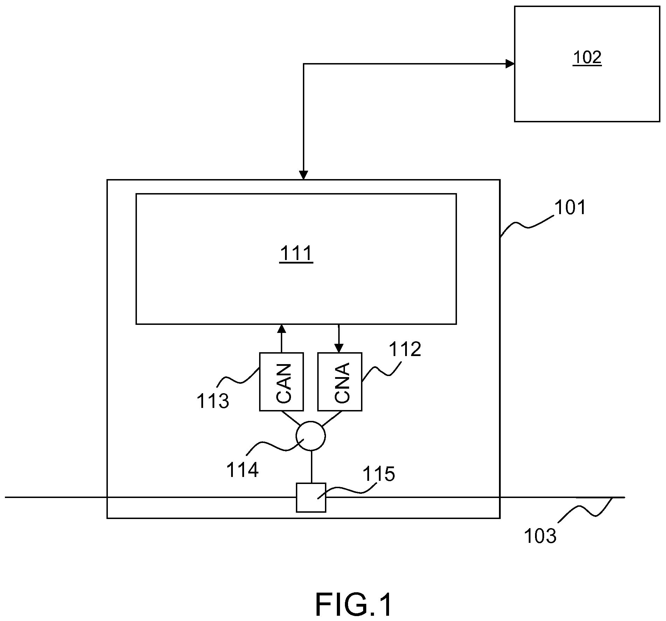

La figure 1 schématise, sur un synoptique, un dispositif de réflectométrie 101 d'un système de réflectométrie distribuée comportant au moins deux dispositifs de ce type.

Un dispositif de réflectométrie 101, ou réflectomètre, comporte au moins un composant électronique 111 de type circuit intégré, tel un circuit à logique programmable, par exemple de type FPGA ou micro-contrôleur, un convertisseur numérique-analogique 112 pour injecter un signal de test dans le câble à tester 103, un convertisseur analogique-numérique 113 pour recevoir le signal réfléchi sur les discontinuités d'impédance ou singularités du câble, un dispositif de couplage 114 entre le convertisseur analogique-numérique 113 et le convertisseur numérique-analogique 112 et un moyen de couplage 115 entre une entrée/sortie du dispositif 101 et le câble à tester 103. Le moyen de couplage est adapté à injecter le signal de sortie du convertisseur numérique-analogique 112 dans le câble 103 et à recevoir le ou les signaux réfléchis.

Le dispositif 101 peut être mis en oeuvre par une carte électronique sur laquelle sont disposés les différents éléments 112,113,114 qui le composent. Le moyen de couplage et d'injection 115 est connecté à une entrée/sortie que comporte la carte.

En outre, une unité de traitement 102, de type ordinateur, assistant numérique personnel ou autre peut être utilisée pour piloter le dispositif de réflectométrie 101 et afficher les résultats des mesures sur une interface homme-machine.

Le composant électronique 111 met en oeuvre d'une part les étapes de traitement nécessaires à la génération du signal d'injection et d'autre part une analyse du signal réfléchi afin d'en déduire un réflectogramme qui est transmis à l'unité de traitement 502.

Le moyen de couplage et d'injection 115 peut être réalisé par effet capacitif, inductif, ou avec une connexion ohmique. Ils peuvent être mis en oeuvre par des moyens de connexion physique.

Un système de réflectométrie distribué comporte au moins deux dispositifs de réflectométrie 101 disposés en deux points distants d'un même câble à tester 103 ou d'un réseau de câble. Les signaux injectés par chaque système de réflectométrie perturbent alors mutuellement les acquisitions des signaux réfléchis.

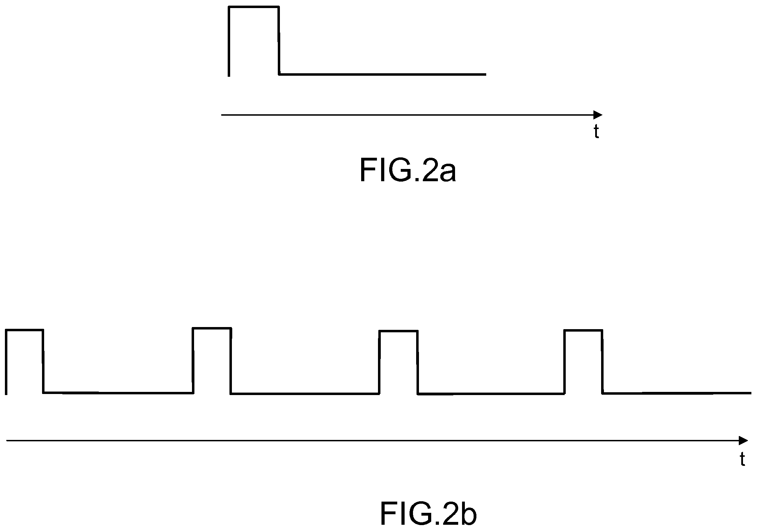

On développe à présent le problème technique que cherche à résoudre l'invention sur un exemple, non limitatif, de système distribué comprenant deux réflectomètres A et B positionnés en deux points distants d'un même câble. A titre purement illustratif, on représente le signal injecté par l'un ou l'autre des réflectomètres A ou B dans le câble par un vecteur dont chaque valeur représente l'amplitude du signal à un instant ou un échantillon de ce signal. On choisit comme exemple une séquence d'un signal impulsionnel comprenant quatre échantillons et représenté par le vecteur (1 0 0 0) dont une représentation temporelle est donnée à la figure 2a. Le choix d'un nombre d'échantillons égal à quatre et d'une amplitude du signal égale à 0 ou 1 est pris à titre de simplification mais le signal injecté peut être de taille et de profil quelconque comme cela sera précisé par la suite.

Afin d'augmenter le rapport signal sur bruit et donc la précision de la localisation d'un défaut impactant le câble à tester, il est nécessaire de moyenner les mesures du signal réfléchi sur plusieurs périodes temporelles. Le signal à injecter doit donc être composé de plusieurs périodes temporelles égales à la séquence de la figure 2a. Sur la figure 2b est représenté le signal complet à injecter, composé de quatre périodes de la séquence de la figure 2a.

Le signal ainsi généré peut être représenté sous la forme matricielle suivante $\begin{pmatrix} 1 & 0 & 0 & 0 \\ 1 & 0 & 0 & 0 \\ 1 & 0 & 0 & 0 \\ 1 & 0 & 0 & 0 \end{pmatrix}$ Chaque ligne de la matrice représente une période du signal de test. L'injection du signal de test et l'acquisition du signal réfléchi sont synchronisées, donc le résultat de la moyenne des acquisitions donne le vecteur $\frac{1}{4}(4 \quad 0 \quad 0 \quad 0)$ ou encore (1 0 0 0). 4

La mesure du signal moyenné est donc identique au signal injecté du fait de la synchronisation de l'injection et de l'acquisition.

On considère à présent un système distribué comprenant deux réflectomètres A et B positionnés sur le même câble et injectant chacun le même signal de test représenté à la figure 2b.

Si l'injection des deux dispositifs n'est pas synchronisée, chaque réflectomètre va recevoir la réflexion des deux signaux superposés et décalés temporellement.

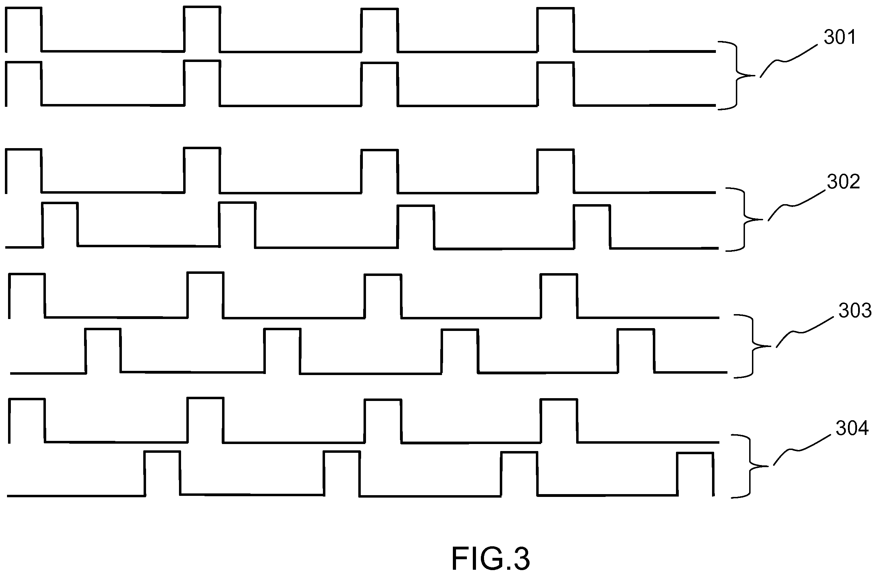

La figure 3 schématise sur quatre chronogrammes les différentes possibilités de désynchronisation entre les deux signaux injectés, pour l'exemple de signal donné à la figure 2b.

Le premier jeu de chronogrammes 301 représente les deux signaux injectés lorsqu'ils sont synchronisés temporellement. Chaque réflectomètre reçoit un signal réfléchi correspondant à la superposition de ces deux signaux qui peut être représentée par la matrice

$\begin{pmatrix} 1_a + 1_b & 0 & 0 & 0 \\ 1_a + 1_b & 0 & 0 & 0 \\ 1_a + 1_b & 0 & 0 & 0 \\ 1_a + 1_b & 0 & 0 & 0 \end{pmatrix}$ où $1_a$ désigne l'amplitude de l'impulsion du signal injecté par le premier réflectomètre A et $1_b$ désigne l'amplitude de l'impulsion du signal injecté par le premier réflectomètre B.

Le deuxième jeu de chronogrammes 302 représente le cas où le second signal est injecté dans le câble avec un retard d'un échantillon par rapport au premier signal. Le signal réfléchi reçu par chaque réflectomètre est donné par la matrice $\begin{pmatrix} 1_a & 1_b & 0 & 0 \\ 1_a & 1_b & 0 & 0 \\ 1_a & 1_b & 0 & 0 \\ 1_a & 1_b & 0 & 0 \end{pmatrix}$

Le troisième jeu de chronogrammes 303 représente le cas où le second signal est injecté dans le câble avec un retard de deux échantillons par rapport au premier signal. Le signal réfléchi reçu par chaque réflectomètre est donné par la matrice $\begin{pmatrix} 1_a & 0 & 1_b & 0 \\ 1_a & 0 & 1_b & 0 \\ 1_a & 0 & 1_b & 0 \\ 1_a & 0 & 1_b & 0 \end{pmatrix}$

Le quatrième jeu de chronogrammes 304 représente le cas où le second signal est injecté dans le câble avec un retard de trois échantillons par rapport au premier signal. Le signal réfléchi reçu par chaque réflectomètre est donné par la matrice $\begin{pmatrix} 1_a & 0 & 0 & 1_b \\ 1_a & 0 & 0 & 1_b \\ 1_a & 0 & 0 & 1_b \\ 1_a & 0 & 0 & 1_b \end{pmatrix}$

Après calcul de la moyenne sur les quatre périodes du signal injecté, on obtient selon les cas, les résultats suivants (2 0 0 0) ou (1 1 0 0) ou (1 0 1 0) ou (1 0 0 1).

Ainsi, on remarque que la moyenne résultante est perturbée par l'injection d'un second signal de test et le résultat de la mesure sur le signal réfléchi dépend de l'asynchronisme entre les deux réflectomètres. Il n'est alors pas possible d'exploiter cette mesure pour en déduire la localisation d'un défaut dans le câble.

En outre, les horloges des deux réflectomètres peuvent subir une dérive qui, même si elle est infime, peut entrainer au fil du temps un décalage entre les injections des deux signaux même si les réflectomètres sont initialement correctement synchronisés.

Afin de supprimer ou limiter l'influence mutuelle des deux signaux de tests injectés sur les mesures de réflectométrie, l'invention consiste à configurer l'un des deux signaux en ajoutant un retard contrôlé à chaque injection d'une période du signal de test.

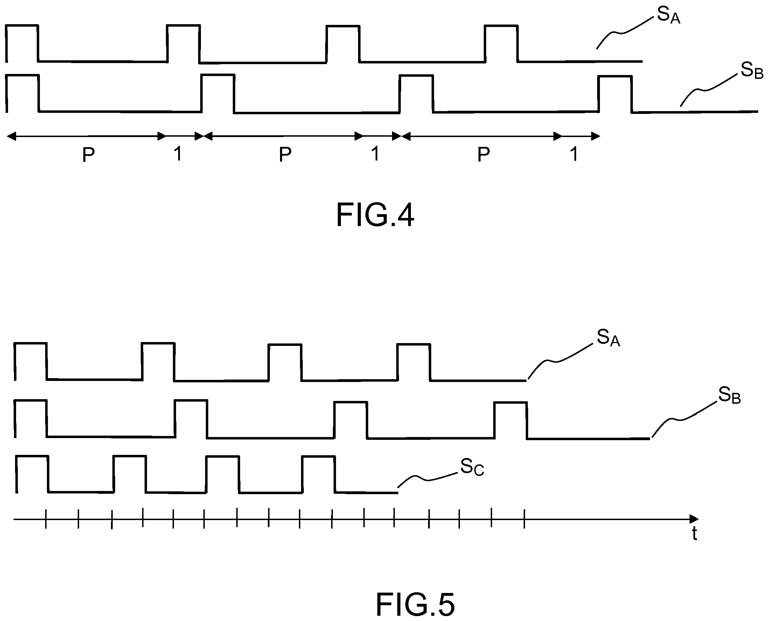

La figure 4 schématise, toujours pour l'exemple de signal de test de la figure 2b, la configuration des signaux mise en oeuvre par l'invention. Le premier signal $S_A$ injecté par le premier réflectomètre est celui déjà présenté à la figure 2b. Le second signal $S_B$ injecté par le second réflectomètre est constitué de quatre périodes P identiques. Chaque période étant retardée d'un retard contrôlé avant son injection. Le retard est configuré de la façon suivante. Le retard d'injection de la première période P est nul.

Un retard complémentaire d'un échantillon est ensuite ajouté à l'injection de chaque période successive comme illustré à la figure 4.

Le même résultat peut également être obtenu en générant le second signal $S_B$ à partir de quatre périodes d'une séquence comportant cinq échantillons, c'est-à-dire un échantillon de plus que le premier signal $S_A$.

En configurant le second signal $S_B$ de la façon décrite ci-dessus, le réflectomètre A, dont l'acquisition est synchronisée sur l'injection du premier signal $S_A$, observera un signal réfléchi qui peut être représenté par la

matrice suivante $\begin{pmatrix} 1_a+1_b & 0 & 0 & 0 \\ 1_a & 1_b & 0 & 0 \\ 1_a & 0 & 1_b & 0 \\ 1_a & 0 & 0 & 1_b \end{pmatrix}$.

En faisant la moyenne sur les quatre acquisitions, on obtient le signal représenté par le vecteur $\frac{1}{4}(5 \quad 1 \quad 1 \quad 1)$.

Si l'on se place à présent du point de vue du second réflectomètre B, dont l'acquisition est synchronisée sur l'injection du second signal $S_B$ et qui est réalisée sur quatre échantillons de chaque période (pour avoir une mesure cohérente avec celle du réflectomètre A), on observe un signal réfléchi représenté par la matrice

suivante $\begin{pmatrix} 1_b+1_a & 0 & 0 & 0 \\ 1_b & 0 & 0 & 1_a \\ 1_b & 0 & 1_a & 0 \\ 1_b & 1_a & 0 & 0 \end{pmatrix}$. et on obtient, après moyenne sur les quatre acquisitions, un signal représenté par le vecteur $\frac{1}{4}(5 \quad 1 \quad 1 \quad 1)$ qui est donc identique à celui mesuré par le premier réflectomètre A. Les mesures obtenues après moyenne par les deux réflectomètres A et B sont similaires à une période du signal de test injecté représentée par le vecteur (1 0 0 0) dans le sens où l'impulsion de signal est détectable et localisée sur le premier échantillon comme à l'injection. La composante continue, égale à ¼ dans ce cas, peut être éliminée et cette composante tend vers une valeur nulle lorsque la profondeur de moyennage augmente.

En résumé, le procédé selon l'invention consiste à mettre en oeuvre les étapes suivantes. Un premier signal de test $S_A$ est injecté dans le câble en un premier point par un premier réflectomètre A. Le premier signal $S_A$ est composé d'un nombre N de périodes consécutives de la même séquence d'un signal. Dans l'exemple de la figure 2b, cette séquence est une impulsion comprenant un échantillon d'amplitude égale à 1 et trois échantillons de valeur nulle. Tout autre signal de test adapté pour réaliser un diagnostic des défauts du câble par réflectométrie est envisageable. On note M le nombre d'échantillons de signal contenus dans une période. Un second signal de test $S_B$ est injecté dans le câble en un second point par un second réflectomètre B. Le second signal $S_B$ est composé du même nombre N de périodes consécutives de la même séquence d'un signal, identique ou différent du premier signal utilisé pour composer le signal $S_A$. Chaque période comporte le même nombre d'échantillons M qu'une période du premier signal $S_A$.

Chaque période du second signal $S_B$ est injectée dans le câble avec un retard contrôlé T initialement nul puis fixé à un nombre donné K d'échantillons pour chaque période successive. Dans l'exemple de la figure 4, K est pris égal à 1. La durée d'un échantillon est par exemple égale à une période d'horloge du réflectomètre. Le retard est réinitialisé à une valeur nulle lorsque toutes les périodes du second signal $S_B$ ont été injectées dans le câble. Autrement dit, dans le cas d'un signal composé de quatre périodes, la première période est injectée avec un retard nul et les périodes suivantes sont injectées avec un retard temporel équivalent de K échantillons.

Dans une variante de réalisation de l'invention, au lieu d'insérer un retard à l'injection de chaque période du second signal $S_B$, il est aussi possible d'ajouter K échantillons de signal à la fin de chaque période, ce qui est équivalent à l'insertion de retards contrôlés et produit le même effet désiré.

De façon générale, chaque période dudit second signal $S_B$ est injectée dans le câble avec un retard ou une avance de valeur absolue prédéterminé(e) pour chaque période successive.

Avantageusement, le nombre K d'échantillons ajoutés ou le retard temporel de durée égale à la durée de K échantillons de signal est configuré de sorte que le nombre d'échantillons par période M est égal au nombre de périodes N que multiplie le nombre d'échantillons K. De cette façon, on assure que chaque signal injecté $S_A$, $S_B$ par un des réflectomètres ne perturbe pas la mesure de réflectométrie réalisée par un autre réflectomètre car le décalage de chaque période de ce signal entraine, après calcul de la moyenne, une atténuation de ce signal. Ainsi, l'interférence mutuelle entre les deux signaux injectés est annulée, ou fortement limitée, après l'acquisition et la moyenne des signaux réfléchis sur les N périodes.

Chaque réflectomètre réalise une acquisition du signal réfléchi dans le câble, puis une moyenne du résultat sur les N périodes. Pour un réflectomètre donné, l'injection est synchronisée avec l'acquisition. Ainsi, pour le second réflectomètre B, l'acquisition est réalisée sur le nombre initial M d'échantillons par période, en prenant en compte les retards introduits dans le signal de test injecté $S_B$. Autrement dit, les acquisitions des signaux réfléchis doivent être synchronisées sur les injections respectives.

De façon plus générale, l'impulsion de signal représentée à la figure 2b à titre d'exemple peut être remplacée par n'importe quel signal contenant M échantillons d'amplitudes variables.

Une variante de réalisation de l'invention consiste à considérer non pas deux réflectomètres mais trois A,B,C, disposés en trois points distincts $P_A$, $P_B$, $P_C$ d'un même câble. Les points $P_B$, $P_C$ sont disposés de part et d'autre du point $P_A$.

La figure 5 représente les chronogrammes des trois signaux de test injectés par les trois réflectomètres dans le câble sous test.

Le premier réflectomètre A injecte un premier signal, dit de référence, $S_A$, qui est par exemple le signal de la figure 2b.

Le second réflectomètre B injecte un second signal $S_B$ obtenu de la façon décrite ci-dessus par mise en oeuvre du procédé selon l'invention.

Le troisième réflectomètre C injecte un troisième signal $S_C$ qui est obtenu de façon similaire au second signal $S_B$ mais au lieu d'insérer un retard contrôlé au début de chaque période ou d'ajouter un nombre d'échantillons prédéterminé à la fin de chaque période, on procède à l'inverse en avançant chaque période du même décalage temporel multiple de K échantillons que le second signal $S_B$ ou en supprimant un nombre K d'échantillons à chaque période. De cette façon l'influence mutuelle des trois signaux est limitée.

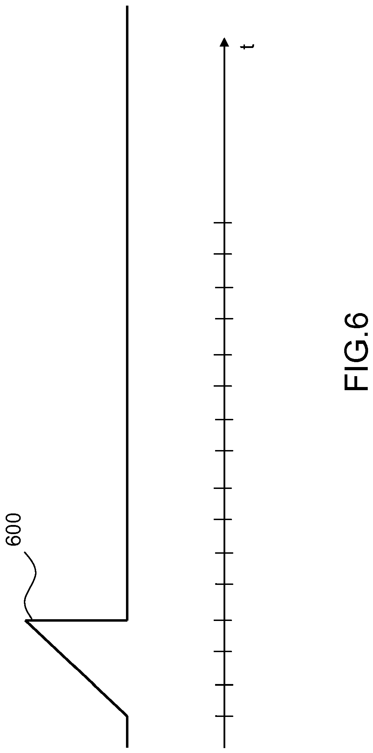

L'invention est compatible de tout type de signaux de test, y compris des signaux à moyenne nulle. Un signal de test avantageusement utilisé pour le diagnostic de câbles de longueur importante est par exemple un signal triangulaire tel que représenté à la figure 6. D'autres signaux de test tel qu'une impulsion ou un créneau temporel comme illustré aux figures 2 à 5 sont également envisageables.

L'invention permet de réaliser une mesure de réflectométrie précise même lorsque les différents dispositifs d'injection d'un signal dans le câble à tester ne sont pas synchronisés temporellement entre eux.

## Revendications

1. Procédé de test d'un câble (103) par réflectométrie distribuée comprenant les étapes suivantes :

- générer un premier signal périodique ($S_A$) et un deuxième signal périodique ($S_B$) comportant le même nombre N de périodes et le même nombre M d'échantillons par période,
- injecter dans le câble (103), en un premier point d'injection, le premier signal périodique ($S_A$), et en un second point d'injection, le deuxième signal périodique ($S_B$),
- acquérir en au moins un point d'observation du câble (103), une mesure de la réflexion, sur les discontinuités d'impédance du câble, de chacun desdits premier et deuxième signaux ($S_A$, $S_B$), ladite acquisition étant synchronisée sur l'injection d'un signal parmi lesdits premier et deuxième signaux ($S_A$, $S_B$),
- moyenner lesdites mesures de la réflexion d'au moins un desdits premier ou deuxième signal ($S_A$, $S_B$) sur l'ensemble de ses périodes pour produire au moins un réflectogramme,
- déterminer les positions de défauts du câble à partir d'au moins ledit réflectogramme,

ledit procédé étant **caractérisé en ce que** chaque période dudit deuxième signal ($S_B$) est injectée dans le câble (103) avec un retard ou une avance de valeur absolue prédéterminée constante.

2. Procédé selon la revendication 1 **caractérisé en ce qu'**une période du premier signal périodique ($S_A$) est identique à une période du deuxième signal périodique ($S_B$).

3. Procédé selon l'une des revendications 1 ou 2 **caractérisé en ce qu'**il comporte en outre les étapes suivantes :

   - Générer un troisième signal périodique ($S_C$) comportant le même nombre N de périodes et le même nombre M d'échantillons par période que ledit premier signal ($S_A$),
   - si les périodes du deuxième signal ($S_B$) sont injectées dans le câble avec un retard, injecter (103) dans le câble chaque période dudit troisième signal ($S_C$) avec une avance,
   - si les périodes du deuxième signal ($S_B$) sont injectées dans le câble avec une avance, injecter (103) dans le câble chaque période dudit troisième signal (Sc) avec un retard,
   - la valeur absolue de l'avance ou du retard à l'injection d'une période du troisième signal ($S_C$) étant prise égale à la valeur absolue du retard ou de l'avance à l'injection d'une période du deuxième signal ($S_B$).

4. Procédé selon la revendication 3 **caractérisé en ce qu'**une période du troisième signal périodique ($S_C$) est identique à une période du premier signal périodique ($S_A$) ou du deuxième signal périodique ($S_B$).

5. Procédé selon l'une des revendications précédentes **caractérisé en ce que** la valeur absolue du retard ou de l'avance est nulle pour la première période et est égale à un écart temporel équivalent à un nombre K d'échantillons de signal pour chaque période successive.

6. Procédé selon l'une des revendications précédentes **caractérisé en ce que** pour obtenir le retard ou l'avance, chaque période est augmentée ou diminuée d'un nombre K d'échantillons.

7. Procédé selon l'une des revendications 5 ou 6 **caractérisé en ce que** le nombre d'échantillons M d'une période est égal à K fois le nombre N de périodes sur lequel est réalisée la moyenne.

8. Procédé selon l'une des revendications précédentes **caractérisé en ce que** lesdits signaux périodiques ($S_A$,$S_B$,$S_C$) sont sélectionnés parmi les signaux suivants : une impulsion temporelle, un créneau temporel, un signal triangulaire, un signal à moyenne nulle.

9. Système de réflectométrie distribuée comprenant au moins un premier et un second dispositifs de test par réflectométrie disposés en au moins deux points distincts d'un même câble (103) à tester **caractérisé en ce que** chaque dispositif comprend des moyens adaptés à mettre en oeuvre le procédé de test selon l'une des revendications 1 à 8.

**Patentansprüche**

1. Testverfahren für ein Kabel (103) mittels verteilter Reflektometrie, das die folgenden Schritte aufweist:

   - Generieren eines ersten periodischen Signals ($S_A$) und eines zweiten periodischen Signals ($S_B$), die dieselbe Anzahl N von Perioden und dieselbe Anzahl M von Proben pro Periode aufweisen,
   - Injizieren des ersten periodischen Signals ($S_A$), an einem ersten Injektionspunkt und des zweiten periodischen Signals ($S_B$) an einem zweiten Injektionspunkt in das Kabel (103),
   - Erfassen, an mindestens einem Beobachtungspunkt des Kabels (103), einer Messung der Reflexion an den Impedanzdiskontinuitäten des Kabels von jedem des ersten und zweiten Signals ($S_A$, $S_B$), wobei das Erfassen auf die Injektion eines Signals von dem ersten und zweiten Signal ($S_A$, $S_B$) synchronisiert ist,
   - Mitteln der Messungen der Reflexion von mindestens einem des ersten oder zweiten Signals ($S_A$, $S_B$) über die Gesamtheit seiner Perioden, um mindestens ein Reflektogramm zu erstellen,
   - Bestimmen der Stellen von Fehlern im Kabel ausgehend von mindestens dem Reflektogramm,

   wobei das Verfahren **dadurch gekennzeichnet ist, dass** jede Periode des zweiten Signals ($S_B$) in das Kabel (103) mit einer Verzögerung oder einem Vorsprung mit einem konstanten vorbestimmten Absolutwert injiziert wird.

2. Verfahren nach Anspruch 1, **dadurch gekennzeichnet, dass** eine Periode des ersten periodischen Signals ($S_A$) mit einer Periode des zweiten periodischen Signals ($S_B$) identisch ist.

3. Verfahren nach einem der Ansprüche 1 oder 2, **dadurch gekennzeichnet, dass** es des Weiteren die folgenden Schritte aufweist:

   - Generieren eines dritten periodischen Signals ($S_C$), das dieselbe Anzahl N von Perioden und dieselbe Anzahl M von Proben pro Periode wie das erste Signal ($S_A$), aufweist,
- wenn die Perioden des zweiten Signals ($S_B$) mit einer Verzögerung in das Kabel injiziert werden, Injizieren (103) jeder Periode des dritten Signals ($S_C$) mit einem Vorsprung in das Kabel,
- wenn die Perioden des zweiten Signals ($S_B$) mit einem Vorsprung in das Kabel injiziert werden, Injizieren (103) jeder Periode des dritten Signals ($S_C$) mit einer Verzögerung in das Kabel,
- wobei der Absolutwert des Vorsprungs oder der Verzögerung bei der Injektion einer Periode des dritten Signals ($S_C$) gleich dem Absolutwert der Verzögerung oder des Vorsprungs bei der Injektion einer Periode des zweiten Signals ($S_B$) angenommen wird.

**4.** Verfahren nach Anspruch 3, **dadurch gekennzeichnet, dass** eine Periode des dritten periodischen Signals ($S_C$) mit einer Periode des ersten periodischen Signals ($S_A$) oder des zweiten periodischen Signals ($S_B$) identisch ist.

**5.** Verfahren nach einem der vorhergehenden Ansprüche, **dadurch gekennzeichnet, dass** der Absolutwert der Verzögerung oder des Vorsprungs für die erste Periode null ist und gleich einem zeitlichen Abstand ist, der einer Anzahl K von Signalproben für jede aufeinanderfolgende Periode gleichwertig ist.

**6.** Verfahren nach einem der vorhergehenden Ansprüche, **dadurch gekennzeichnet, dass** zum Erhalten der Verzögerung oder des Vorsprungs jede Periode um eine Anzahl K von Proben erhöht oder verringert wird.

**7.** Verfahren nach einem der Ansprüche 5 oder 6, **dadurch gekennzeichnet, dass** die Anzahl der Proben M einer Periode gleich der K-fachen Anzahl N von Perioden ist, auf der die Mittelung erfolgt.

**8.** Verfahren nach einem der vorhergehenden Ansprüche, **dadurch gekennzeichnet, dass** die periodischen Signale ($S_A$, $S_B$, $S_C$) aus den folgenden Signalen ausgewählt werden: einem kurzzeitigen Impuls, einem Zeitschlitz, einem dreieckigen Signal, einem Signal mit Durchschnittswert null.

**9.** System für verteilte Reflektometrie, aufweisend mindestens eine erste und eine zweite Vorrichtung zum Testen mittels verteilter Reflektometrie, die an mindestens zwei verschiedenen Punkten eines zu prüfenden selben Kabels (103) angeordnet sind, **dadurch gekennzeichnet, dass** jede Vorrichtung Mittel aufweist, die angepasst sind, um das Testverfahren gemäß einem der Ansprüche 1 bis 8 umzusetzen.

**Claims**

**1.** A method of testing a cable (103) by distributed reflectometry, comprising the following steps:

- generating a first periodic signal ($S_A$) and a second periodic signal ($S_B$) having the same number N of periods and the same number M of samples per period,
- injecting into the cable (103), at a first injection point, the first periodic signal ($S_A$), and, at a second injection point, the second periodic signal ($S_B$),
- acquiring, at at least one cable (103) observation point, a measurement of the reflection, from impedance discontinuities of the cable, of each of said first and second signals ($S_A$, $S_B$), said acquisition being synchronized with the injection of a signal from among said first and second signals ($S_A$, $S_B$),
- taking the average of said measurements of the reflection of at least one of said first or second signals ($S_A$, $S_B$) over all of its periods to produce at least one reflectogram,
- determining the positions of faults in the cable on the basis of at least said reflectogram,

said method being **characterized in that** each period of said second signal ($S_B$) is injected into the cable (103) with a delay or an advance having a constant predetermined absolute value.

**2.** The method according to claim 1, **characterized in that** a period of the first periodic signal ($S_A$) is identical to a period of the second periodic signal ($S_B$).

**3.** The method according to any of claims 1 or 2, **characterized in that** it further includes the following steps:

- generating a third periodic signal ($S_C$) having the same number N of periods and the same number M of samples per period as said first signal ($S_A$),
- if the periods of the second signal ($S_B$) are injected into the cable with a delay, injecting (103) into the cable each period of said third signal ($S_C$) with an advance,
- if the periods of the second signal ($S_B$) are injected into the cable with an advance, injecting (103) into the cable each period of said third signal ($S_C$) with a delay,
- the absolute value of the advance or delay at the injection of a period of the third signal ($S_C$) being set equal to the absolute value of the delay or the advance at the injection of a period of the second signal ($S_B$).

4. The method according to claim 3, **characterized in that** a period of the third periodic signal ($S_C$) is identical to a period of the first periodic signal ($S_A$) or of the second periodic signal ($S_B$).

5. The method according to any of the preceding claims, **characterized in that** the absolute value of the delay or the advance is zero for the first period and is equal to a time difference equivalent to a number K of signal samples for each successive period.

6. The method according to any of the preceding claims, **characterized in that** each period is increased or decreased by a number K of samples in order to obtain the delay or advance.

7. The method according to any of claims 5 or 6, **characterized in that** the number of samples M of a period is equal to K times the number N of periods over which the average is taken.

8. The method according to any of the preceding claims, **characterized in that** said periodic signals ($S_A$, $S_B$, $S_C$) are selected from among the following signals: a temporal pulse, a time slot, a triangular signal, and a zero-average signal.

9. A distributed reflectometry system comprising at least a first and a second reflectometry test device positioned at at least two separate points of the same cable (103) to be tested, **characterized in that** each device comprises means adapted for executing the test method according to any of claims 1 to 8.

FIG.1

EP 2 834 653 B1

FIG.2a

FIG.2b

FIG.3

EP 2 834 653 B1

FIG.4

FIG.5

FIG.6

## RÉFÉRENCES CITÉES DANS LA DESCRIPTION

**Documents brevets cités dans la description**

- FR 2907910

- WO 2010043602 A

**Littérature non-brevet citée dans la description**

- **ADRIEN LELONG.** *Méthodes de diagnostic filaire embarqué pour des réseaux complexes,* 09 Décembre 2010